# EUROPEAN PATENT APPLICATION

(11) **EP 4 523 918 A1**
(43) Date of publication of application: **19.03.2025**
(21) Application number: 23196914.8
(22) Date of filing: 12.09.2023
(51) Int. Cl.: B41J 3/28, B41J 2/005, B41J 2/32, B41J 2/01, H01L 21/67

(54) **DEPOSITION METHOD AND DEVICE**

(71) Applicant: FononTech Holding B.V., 5581 WG Waalre (NL)
(72) Inventor: HENDRIKS, Rob Jacob, 5581 WG Waalre (NL)
(74) Representative: V.O.

(57) **Abstract**

An improved deposition method is provided for depositing a functional material (FM) onto a target surface (TS) of a target (T). The method comprises:
providing (S1) a donor plate surface (21s) of a donor plate (21) with a functional material species (FM') of the functional material (FM);
supplying (S2) heat to the donor plate surface to expel the functional material species (FM') away therefrom;
characterized by:
receiving (S3) on a transfer surface (41s) of a transfer plate (41) the expelled functional material species (FM'); and
supplying (S4) heat to the transfer surface (41s) of the transfer plate (41) to transfer the functional material species (FM') for deposition on the target surface (TS) of the target (T).

Also a deposition system is provided as well as a record carrier comprising computer program with instructions for performing the method.

## Description

### BACKGROUND

The present invention pertains to a deposition method for depositing a functional material onto a target surface of a target.

The present invention further pertains to a deposition device for depositing a functional material onto a target surface of a target.

The present invention still further pertains to a record carrier comprising a computer program with instructions to cause a programmable device to perform a deposition method for depositing a functional material onto a target surface of a target.

Deposition methods are known wherein a functional material to be deposited is ejected from a surface of a donor plate onto a surface of a target. Ejection is achieved by a thermally induced transfer. Therein heat supplied to the surface of the donor plate causes a portion of the functional material at the interface with the donor plate surface to evaporate, therewith inducing a vapor pressure that expels the functional material from the donor plate surface. The functional material is for example a material that is primarily intended as an electrically conducting material, an electrically semi-conducting material, an electrically insulating material, a thermally conducting material or a thermally insulating material, an optically transparent materials, an optically opaque material. Alternatively the functional material may be intended to have a combination of functionalities referred to. Virtually all functional materials can be deposited in a heat-induced manner for example in the form of a functional ink which may comprise a solution or a dispersion of the functional material. Alternatively or additionally the functional ink may comprise polymerizable components. Exemplary materials are described in https://en.wikipedia.org/wiki/Printed_electronics#:~:text=Printed%20electronics% 20is%20a%20set,%2C%20offset%20lithography%2C%20and%20inkjet.

Heat induced transfer technology of functional materials can be used to form active or passive devices, such as thin film transistors; capacitors; coils; resistors, electrical conductors and the like.

As such, heat induced deposition from a donor plate to a target is a highspeed process. By way of example this deposition can be performed in less than 0.1 s. However, other process steps involving a substantially longer time process time (in the order of seconds) are required to facilitate the heat induced deposition, such as providing the donor plate with new functional material and positioning the donor plate with respect to the target.

Hence, there is a need to minimize the total process time in a heat induced deposition technology for depositing a functional material onto a target surface of a target.

### SUMMARY

In accordance with the above-mentioned need, an improved method is provided.

The improved deposition method for depositing a functional material onto a target surface of a target comprises the following steps:
providing a donor plate surface of a donor plate with a functional material species of the functional material;
supplying heat to the donor plate surface to expel the functional material species away therefrom;
receiving on a transfer surface of a transfer plate the expelled functional material species; and
supplying heat to the transfer surface of the transfer plate to transfer the functional material species for deposition on the target surface of the target.

Contrary to known deposition methods, the functional material species is not directly transferred from the donor plate to the target but indirectly via at least one intermediate transfer step using a transfer plate. Surprisingly this additional step(s) renders possible a higher throughput. This is rendered possible in that the more time-consuming process steps providing the donor plate surface with a functional material species and positioning the transfer plate can be performed at least partially in parallel. The donor plate may have an at least substantially fixed position.

In an embodiment of the deposition method the functional material species is displaced over a first distance after being expelled away from the donor plate and until being received on the transfer surface of the transfer plate, and the functional material species is displaced over a second distance when it is transferred from the transfer surface to the target surface of the target, wherein the second distance is greater than the first distance. In some applications the target surface of the target may have a height profile, for example in case of a target comprising a substrate with components mounted thereon. In this case a functional material species may be transferred over a relatively large distance when it is deposited on the surface of the substrate between components.

This embodiment of the deposition method is particularly favorable for use with a donor plate having a patterned donor plate surface. The donor plate surface in this example is patterned with at least one cavity that defines the pattern with which species of the functional material are to be deposited on the target. In this example, the step of providing a donor plate with a functional material species comprises filling the at least one cavity that is patterned in a surface of the donor plate with the functional material species. It has been found by the inventor that heat-induced printing of high resolution patterns (<100 µm) from a patterned donor plate (impulse printing) over relatively large print gaps is problematic. The inventor observed that when filling the at least one cavity of the patterned donor plate surface, for example with a doctor blade, typically a portion of the functional material is dragged out of the cavity. The dragged out portion of the functional material exerts an undesired shear force on the functional material when it is expelled from the cavity, as a result of which the functional material is ejected in a direction deviating from the direction normal to the surface. The deviation can not be accurately predicted as it depends on the amount and shape of the dragged out portion of the functional material, which is not reproducible. Due to the stochastic deviations in the direction of ejection, also the deposition position is affected. Therewith a deposited pattern of functional material species will deviate from the pattern of cavities provided in the donor plate to an extent that is proportional to the distance of transfer.

For a target having a surface height profile, the distance between the donor plate to the target surface cannot be arbitrarily reduced, as the donor plate surface cannot be positioned closer to the target than is allowed by the highest portion of the target surface.

In the above-mentioned embodiment, wherein the second distance is greater than the first distance it is rendered possible to more accurately transfer a pattern of functional material species to a target having a surface height profile. Due to the fact that the surface of the transfer plate can be positioned close to the patterned donor plate it is achieved that shear forces caused by dragged out portions of the functional material only have a modest effect on the location of deposition on the transfer plate. Shear forces in the heat-induced transfer process from the flat surface of the transfer plate to the surface of the target are avoided, so that misalignment and pattern distortion are mitigated regardless the distance over which the functional material material is transferred in this step.

Various further improvements are possible. By way of example the improved method can be performed with one or more further donor plates. Therein a further donor plate surface of a further donor plate is provided with a further functional material species of a further functional material. Likewise the further functional material species is expelled away from the donor plate surface and deposited on the transfer surface of the transfer plate receiving the expelled further functional material species. When supplying heat to the transfer surface of the transfer plate the further functional material species transferred for deposition on the target surface of the target.

In the first place, this modification allows for a further speedup of the deposition method as transfer plate can be more efficiently used.

In the second place, this modified embodiment facilitates more complicated deposition operations. For example, the further functional material and the functional material can be selected as mutually different substances. For example the selected functional material is electrically conductive substance and the selected further functional material is an electrically insulating substance.

Furthermore the donor plate and the further donor plate may have mutually different characteristics, for example one of them may be patterned, while the other is not, or they may have mutually different surface patterns.

In an embodiment the functional material species and the further functional material species are transferred simultaneously when supplying heat to the transfer surface of the transfer plate. For example in a first operation a first pattern of functional material species is transferred from the donor plate to the transfer plate, in a second operation a second pattern of further functional material species is transferred from the further donor plate to the transfer plate, and in a third operation the first pattern and the second pattern are simultaneously transferred from the transfer plate to the target.

According to a second aspect an improved deposition system is provided. The improved deposition system for depositing a functional material onto a target surface of a target comprises a target holder, a deposition unit, a functional material supply device, a positioning mechanism and a controller.

The target holder is configured for holding the target of which the target surface is to be deposited with the functional material.

The deposition unit is configured for holding a donor plate with a donor plate surface. The donor plate may be an integral part of the deposition unit or may be removeable for exchange by another donor plate. The deposition unit comprises a heat supply facility, for example a resistive heat supply, configured to supply heat to the donor plate surface.

The functional material supply device is configured to provide the donor plate surface with a functional material species of the functional material.

Characteristic for the improved deposition device is the transfer unit configured for holding a transfer plate with a transfer plate surface. The transfer unit comprises a further heat supply facility that is configured to supply heat to the transfer surface of the transfer plate.

The positioning mechanism is configured to controllably position the various components of the deposition system relative to each other and the controller is configured to control the operation of these components as well as the positioning mechanism.

The deposition system has at least a first and a second deposition mode. In the first deposition mode the functional material species is transferred from the donor plate to the transfer plate with the donor plate facing the transfer plate. In the second deposition mode the functional material species is transferred from the transfer plate to the target with the transfer plate facing the target.

In operation of the improved deposition system the functional material species is indirectly transferred from the donor plate to the target. In the first deposition mode the functional material species is transferred from the donor plate to the transfer plate and in the second deposition mode the functional material species is transferred from transfer plate to the target. As set out above this indirect transfer procedure renders possible a higher throughput.

In the first operational mode the functional material species is transferred over a first distance from the surface of the donor plate to the transfer surface of the transfer plate. In the second deposition mode the functional material species is transferred over a second distance from the transfer surface to the target surface. In exemplary embodiments the improved deposition system is configured to perform the transfer of the functional material species over a second distance that is greater than the first distance. This is for example achieved in that the improved deposition system is configured to hold the donor plate at a distance to the transfer plate that is just sufficient to avoid that the surface of the transfer plate contacts the donor plate surface or the functional material species thereon before transfer take place in the first mode. In case the surface of the target has a height profile the second distance over which a functional material species is transferred towards a recessed portion of the target surface of the target in the second operational mode is typically substantially greater than the first distance.

In one of the exemplary embodiments the deposition system is configured for holding a donor plate having a donor plate surface patterned with at least one cavity. Although for high resolution pattern elements (<100 micron) shear forces tend to occur that tend to affect the transfer direction in the first operational mode, it is achieved with the small first transfer distance that this has only a minor effect on the deposition position of the functional material substance on the surface of the transfer plate. The subsequent transfer of the functional material substance from the transfer plate to the target surface of the target can take place without substantial deviations, even if the second distance is relatively large.

In some embodiments the improved deposition system further comprises
at least a further deposition unit for further donor plate having a donor plate surface;
at least a further functional material supply device configured to provide the donor plate surface of the further donor plate with a further functional material species;
the positioning mechanism being configured to controllably position the functional material supply device, the further functional material supply device, the deposition unit, the further deposition unit, the transfer unit and the target relative to each other;
the deposition system further having a third deposition mode, wherein the further functional material species is transferred over a third distance from the further donor plate to the transfer plate.

These embodiments provide additional advantages. For example a further speedup can be realized by a more time-efficient operation of the transfer unit. Also, the further functional material supply device and the further deposition unit facilitate a more efficient deposition of mutually different functional materials in mutually different patterns and the like.

According to a third aspect of the present invention a record carrier is provided that comprises a computer program with instructions to cause a programmable device to perform a deposition method for depositing a functional material onto a target surface of a target.

### BRIEF DESCRIPTION OF THE DRAWINGS

FIG. 1A - FIG. 1H schematically show an embodiment of the improved deposition system in subsequent operational states;
FIG. 2A and 2B show a conventional deposition method;
FIG. 2C shows a simulation of the conventional deposition method;
FIG. 3A, 3B, 3C show an embodiment of an improved deposition method;
FIG. 3D shows a simulation of the improved deposition method;
FIG. 4A, 4B and 4C schematically show a further embodiment of the improved deposition system in subsequent operational states;
FIG. 4D shows operations performed by this embodiment as a function of time;
FIG. 5 shows a still further embodiment of the improved deposition system.

### DETAILED DESCRIPTION OF EMBODIMENTS

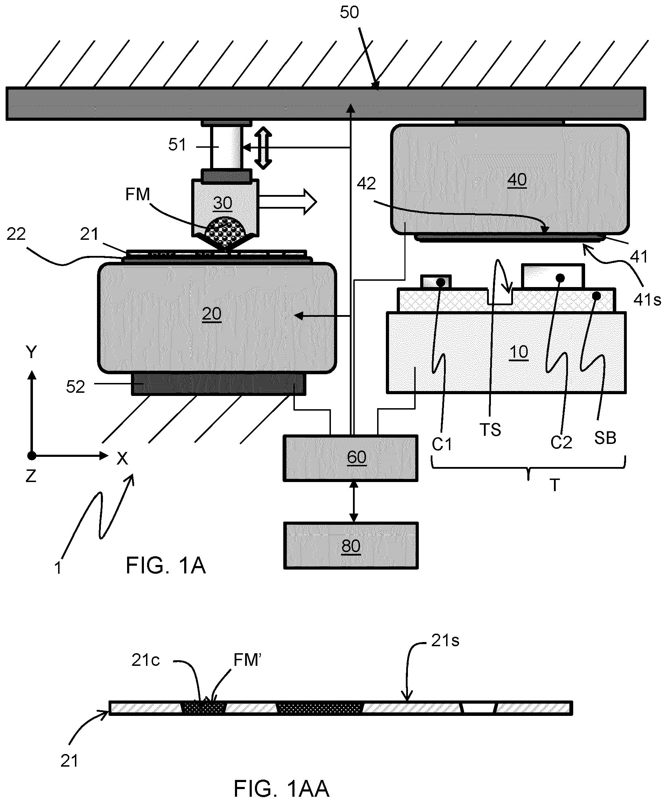

FIG. 1A - FIG. 1H schematically show an embodiment of the improved deposition system 1 in subsequent operational states. The improved deposition system 1 as shown therein comprises in FIG. 1A, a target holder 10, a deposition unit 20, a functional material supply device 30, a transfer unit 40, a positioning mechanism 50, 51, 52 and a controller 60.

The target holder 10 is configured to hold a target T. As shown in FIG. 1A the exemplary target T has a target surface TS with a height profile. The target T shown in this example comprises a substrate SB with components C1, C2.

The deposition unit 20 is configured to hold a donor plate 21 (See also FIG. 1AA) that has a donor plate surface 21s. The donor plate 21 may be an integral part of the deposition unit 20, but typically the donor plate 21 is removable, so that it can be exchanged for another one. The functional material supply device 30 is configured to provide the donor plate surface 21s with a functional material species FM' of the functional material FM. The functional material is for example a conductive material or paste. An example of a conductive adhesives is a thermal or UV settable resin loaded with silver particles, or a solder paste comprising solder particles and flux. Alternatively it may be desired to locally deposit an insulating element, for example to electrically insulate an electric conductor from another, crossing electric conductor. Still further the functional material to be deposited may be a thermal conductor, or instead a thermal insulator. Typically a functional material needs to be formulated with other materials before the functional material can be printed on a substrate. A formulation can e.g. be formed by dispersing the functional material in a solvent or liquid; thus, the formulation is generally wet. The formulation is often referred to as an ink or paste, depending on the viscosity.

The formulation preferably comprises one or more of a solvent, an acrylate type polymer, an epoxy type polymer or a silicone type polymer. These materials evaporate at relatively modest temperatures, which facilitates the transfer process. Acrylate, epoxy and silicone type polymers are also suitable for deposition as electrically insulating materials. In some examples the formulation further comprise one or more solid state materials. For example in case it is desired that the material deposited on the target surface is electrically conductive, the formulation may comprises silver and/or copper particles as the solid state material. In some examples the formulation of the functional material is a solder. In some examples a viscosity of a solvent based formulation is increased by addition of a binder.

Accordingly, a non-limitative set of example for a formulation of the functional material is as follows:
Solid state materials (Ag, Cu) + solvent
Solid state materials (Ag, Cu) + polymer binder + solvent
Acrylates
Acrylates + solvent(s)
Acrylates + solid state materials
Acrylates + solid state materials + solvent(s)
Epoxy's
Epoxy's + solvent(s)
Epoxy's + solid state materials
Epoxy's+ solid state materials + solvent(s)
Silicones
Silicones + solvent(s)
Silicones + solid state materials
Silicones + solid state materials + solvent(s)

A relatively low evaporation temperature is favorable in order to mitigate energy requirements and for warranting a long lifetime of the deposition system. Hence, preferably at least one component in the formulation has an evaporation temperature of at most 800 _{°}C, preferably at most 600 _{°}C, or even more preferably at most 400 _{°}C.

Preferably a viscosity of the formulation is not too low, e.g. at least 0.1 Pa.s. Some formulations to be deposited are of a high viscosity, e.g. higher than 50 Pa.s to even as much as about 1000 Pa.s (10⁶ cp.s). Such highly viscous materials will not significantly deform due to gravity and flow, but substantial maintain the intended aspect ratio and form definition in the transfer.

In the example shown the donor plate surface 21s is patterned with at least one cavity 21c and the functional material supply device 30 is configured to deposit the functional material species FM' in the at least one cavity 21c. The deposition unit 20 comprises a heat supply facility 22 that is configured to supply heat to the donor plate surface 21s. In an example the heat supply facility 22 is a resistive heater layer. In another example the heat supply facility 22 comprises a photon radiation source, such as a laser to direct photon radiation to the donor plate surface 21s. The transfer unit 40 is configured for holding a transfer plate 41 that has a transfer plate surface 41s and comprises a further heat supply facility 42 that is configured to supply heat to the transfer surface 41s of the transfer plate 41. The transfer plate 41 may be an integral part of the transfer unit 40, but typically the transfer plate 41 is removable, so that it can be exchanged for another one.

The positioning mechanism may comprise various positioning devices to controllably position components of the deposition system relative to each other. In the example shown, the positioning mechanism comprises a linear actuator 50 that is configured to controllably position the functional material supply device 30, and the transfer unit 40 linearly in a direction X. FIG. 1A further shows a further linear actuator 51 to controllably position the functional material supply device 30 in the direction Y. The deposition unit 20 and the target holder 10 have a substantially fixed position, but fine-positioning devices may be provided, for example 52 is a 6 DOF actuator 52 is provided to very accurately position the deposition unit 20 in a controllable manner.

The controller 60 is configured to control various components of the deposition system as is schematically shown by connection lines to the linear actuator 50, the further linear actuator 51, the 6 DOF actuator 52, the deposition unit 20, the transfer unit 40 and the target holder 10. For clarity these connection lines are omitted in the subsequent figures.

In some examples the controller 60 is provided as dedicated hardware which is configured to operate in a predetermined manner. In the example shown, the controller 60 is a programmable device, and is coupled to a record carrier 80 that comprises a computer program with instructions to cause the controller to perform an embodiment of the improved method. This example is advantageous as the improved deposition system is versatile, in that it can be easily adapted to different requirements and circumstances. For example control voltages for heat induced transfer may be adapted for inducing transfer of different substances.

FIG. 1A, 1AA shows the embodiment of the improved deposition system 1 in a first operational state, wherein the controller 60 causes the functional material supply device 30 to provide the donor plate surface 21s of the donor plate 21 with a functional material species FM' of the functional material FM. In this example the functional material supply device 30 fills the at least one cavity 21c that is patterned in the surface 21s of the donor plate 21 with the functional material species FM'.

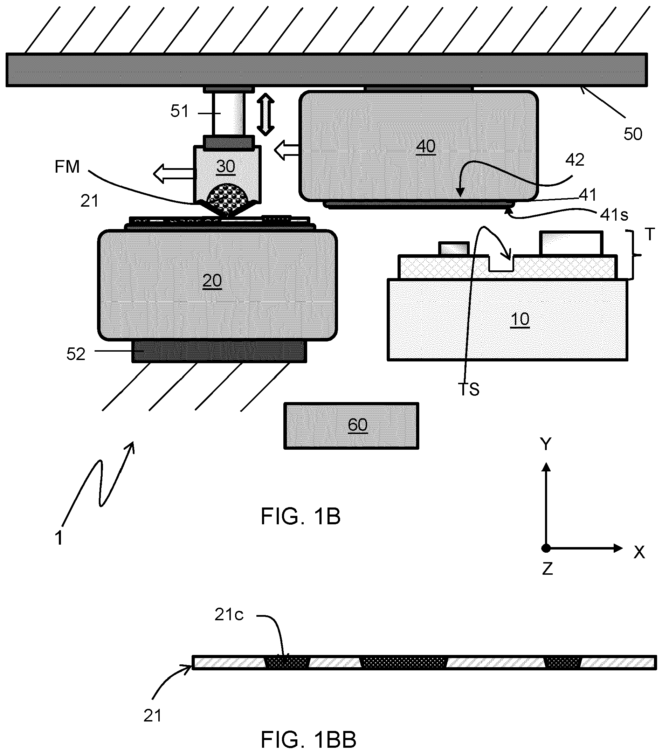

FIG. 1B, 1BB shows the embodiment of the improved deposition system 1 in a second operational state. Once the operation of the functional material supply device 30 is completed the controller 60 causes the linear actuator 50 to move the functional material supply device 30 and the transfer unit 40 in the direction -X, so as to position the deposition unit 20 and the transfer unit 40 opposite each other.

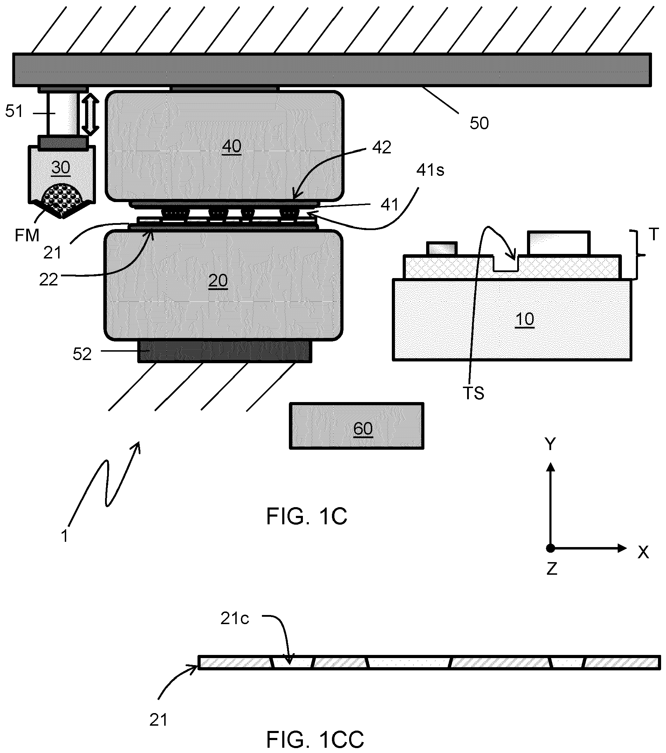

FIG. 1C, 1CC show the embodiment of the improved deposition system 1 in a third operational state corresponding to the first operational mode. In the first operational mode the controller 60 causes the heat supply facility 22 to supply heat to the donor plate surface 21s so as to expel the functional material species FM' from the donor plate surface 21s as a result of which it is transferred to the transfer plate surface 41s of the transfer plate 41 as shown in FIG. 1C.

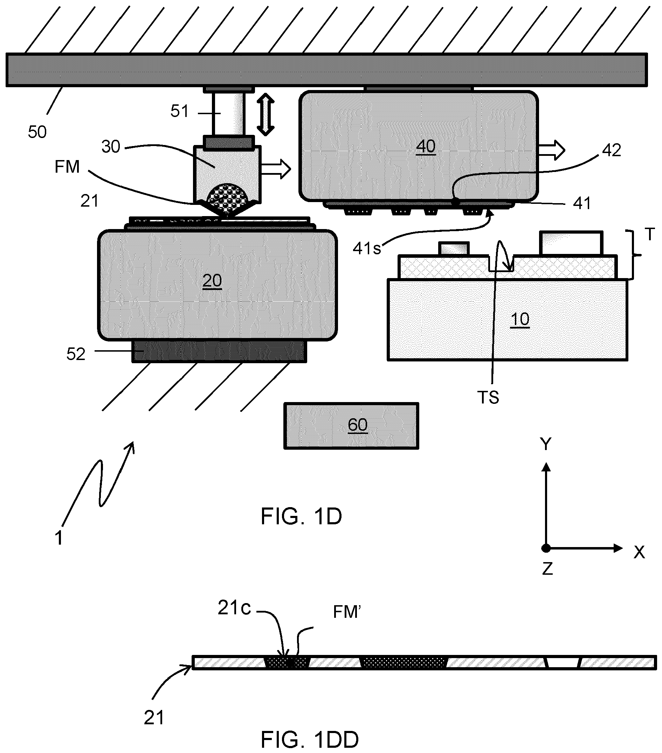

FIG. 1D, 1DD show the embodiment of the improved deposition system 1 in a fourth operational state. In the fourth operational state the controller 60 causes the linear actuator 50 to move in the direction X towards a position wherein the transfer plate surface 41s of the transfer plate 41 faces the target surface TS of the target T. Simultaneously the controller 60 causes the functional material supply device 30 to provide the donor plate surface 21s of the donor plate 21 with a fresh functional material species FM' of the functional material FM. Therewith, in this embodiment, the at least one cavity 21c in the surface 21s of the donor plate 21 is filled with the fresh functional material species FM'.

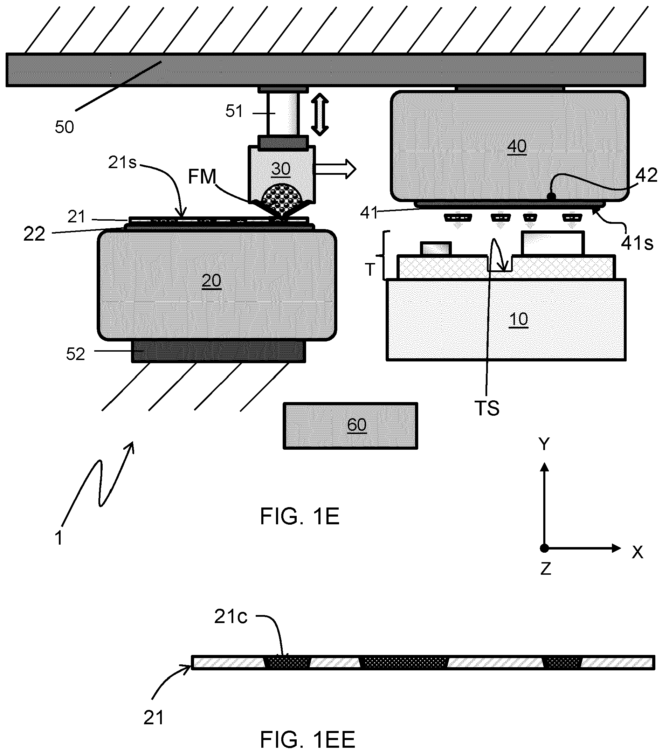

FIG. 1E, 1EE show the embodiment of the improved deposition system 1 in a fifth operational state. In this operational state the controller 60 causes the further heat supply facility 42 to supply heat to the transfer plate surface 41s to expel functional material species FM' from the transfer plate surface 41s. Therewith the pattern of functional material that was deposited on the transfer plate surface 41s is now transferred to the target surface TS. In the example shown the process of providing the donor plate surface 21s of the donor plate 21 with a fresh functional material species FM' of the functional material FM still continues.

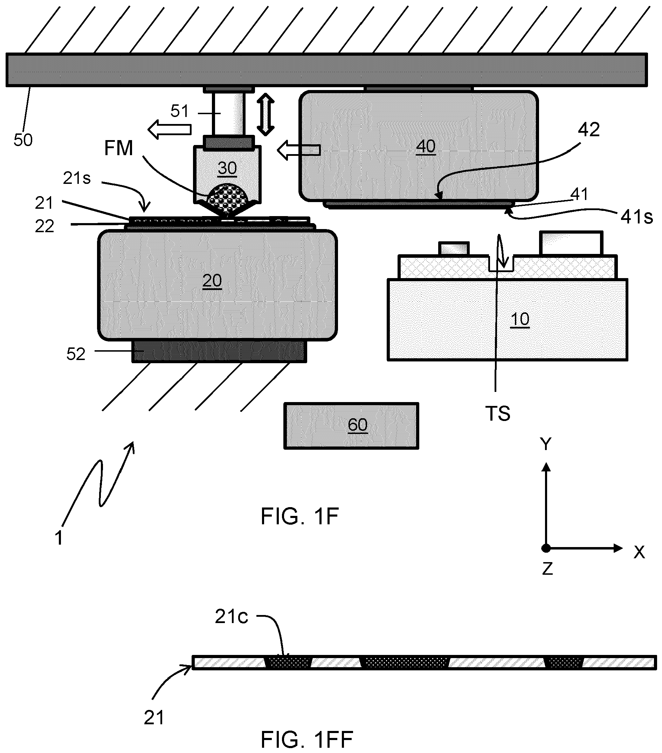

FIG. 1F, 1FF show the embodiment of the improved deposition system 1 in a sixth operational state. In this operational state the controller 60 causes the linear actuator 50 to move the transfer unit 40 in the direction -X towards the position wherein the transfer plate surface 41s faces the donor plate surface 21s. The controller 60 also causes the linear actuator 50 to move the functional material supply device 30 in a direction -X.

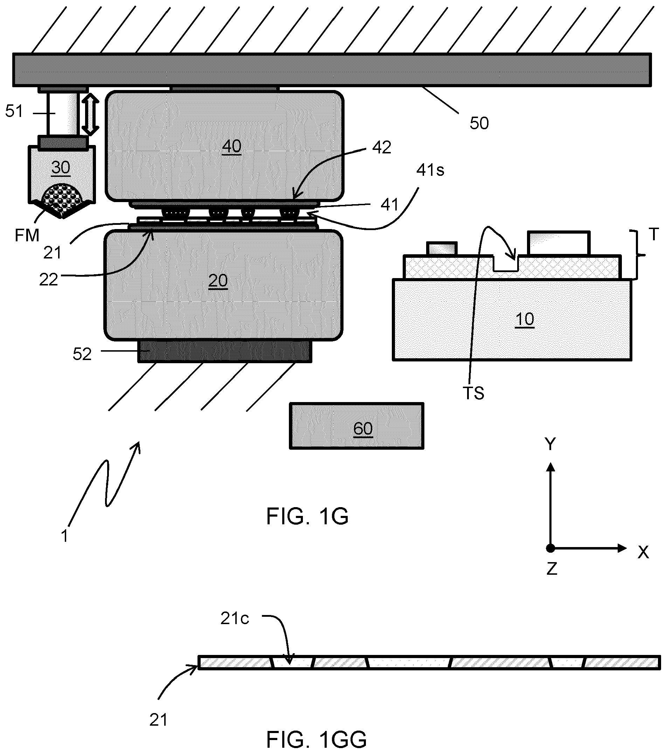

FIG. 1G, 1GG show the embodiment of the improved deposition system 1 in a seventh operational state. The seventh operational state corresponds to the first operational mode wherein the controller 60 causes the heat supply facility 22 to supply heat to the donor plate surface 21s. Therewith functional material species FM' is expelled from the donor plate surface 21s and deposited on the transfer plate surface 41s.

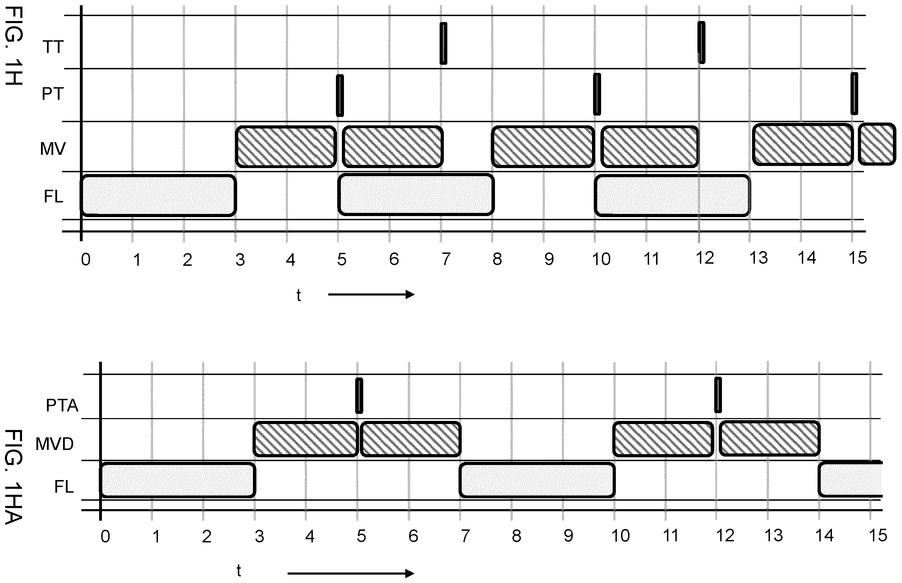

This sequence of operations can be repeated as schematically shown in FIG. 1H. In this diagram the most relevant operations are indicated as follows.

FL: providing the donor plate surface 21s of the donor plate 21 with a functional material species FM' of the functional material FM.

MV: moving the transfer unit 40 in the direction X or -X.

PT: transferring the functional material species FM' from the donor plate surface 21s to the transfer plate surface 41s.

TT: transferring the functional material species FM' from the transfer plate surface 41s to the target surface TS.

As noted above, a heat-induced pattern transfer PT, TT takes place almost instantaneously. It is further presumed that the process FL of providing the donor plate surface 21s with a functional material species FM' requires about 3 time units, e.g. 3 s. It is further presumed that the moving MV the transfer unit 40 in the direction X or -X requires 2 time units, e.g. 2 s.

In this example the first operation as shown in FIG. 1A, 1AA is performed in the time interval 0-3.

The second operation as shown in FIG. 1B, 1BB is performed in the timeinterval 3-5.

In the first operational mode the third operation shown in FIG. 1C, 1CC is performed virtually instantaneously at t=5.

The fourth operation, shown in FIG. 1D, 1DD starts approximately at t=5. In this fourth operation the transfer unit 40 is moved MV in the direction X towards a position opposite the target T, and the donor plate surface 21s of the donor plate 21 is provided FL with a fresh functional material species FM'.

Once the transfer unit 40 is in its position opposite the target T at point in time t=7 the fifth operation is performed as shown in FIG. 1E, 1EE. This comprises a second operational mode wherein the functional material species FM' is transferred from the transfer plate surface 41s to the target surface TS almost instantaneously. The functional material supply device 30 proceeds until t=8. In the time interval t=8-10, illustrated in FIG. 1F, 1FF the transfer unit 40 is moved in the direction -X towards its position opposite the deposition unit 20. Also the functional material supply device 30 moves in that direction towards a standby position. At point in time t=10, shown in FIG. 1G, 1GG, the transfer unit 40 is back in its position opposite the deposition unit 20 as shown in FIG. 1C, 1CC so that at that point in time the pattern of fresh functional species FM' provided on the donor plate surface 21s of the donor plate 21 can be transferred to the transfer plate surface. At this point in time t=10, the improved deposition system 1 has performed a complete deposition cycle in 5 time units.

For comparison FIG. 1HA shows the case wherein functional material is directly transferred from the donor plate to the target. As in the example described in FIG. 1A-1H it is presumed that this functional material transfer, indicated as PTA in the diagram takes place almost instantaneously, that the process of preparing the donor plate with the functional material, denoted as FL requires 3 time units and that the positioning process indicated as MVD requires 2 time units. It can be seen in diagram 1HA that in this case, a complete deposition cycle requires 7 time units despite the fact that functional material transfer from the donor plate to the target is performed directly.

The inventive approach as claimed in the present invention enables an overall more efficient process due to the fact that the actions of positioning MV and preparing the donor plate FL can take place in parallel.

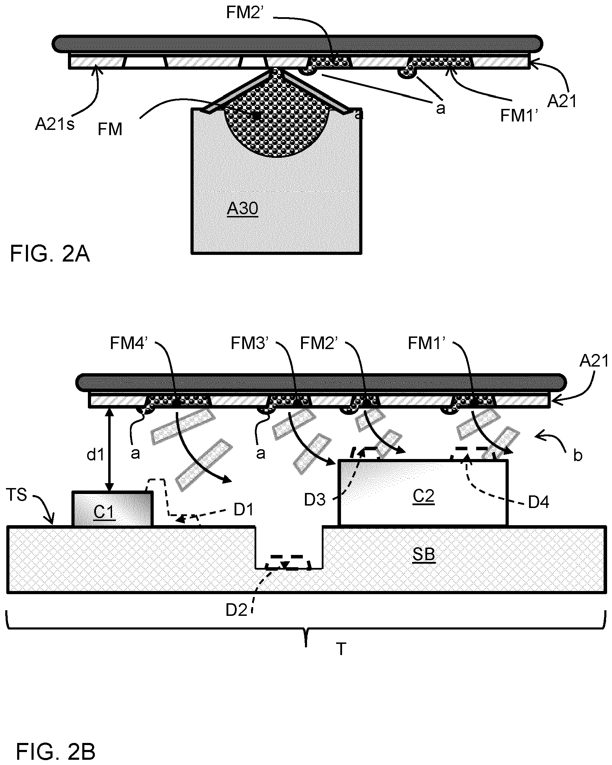

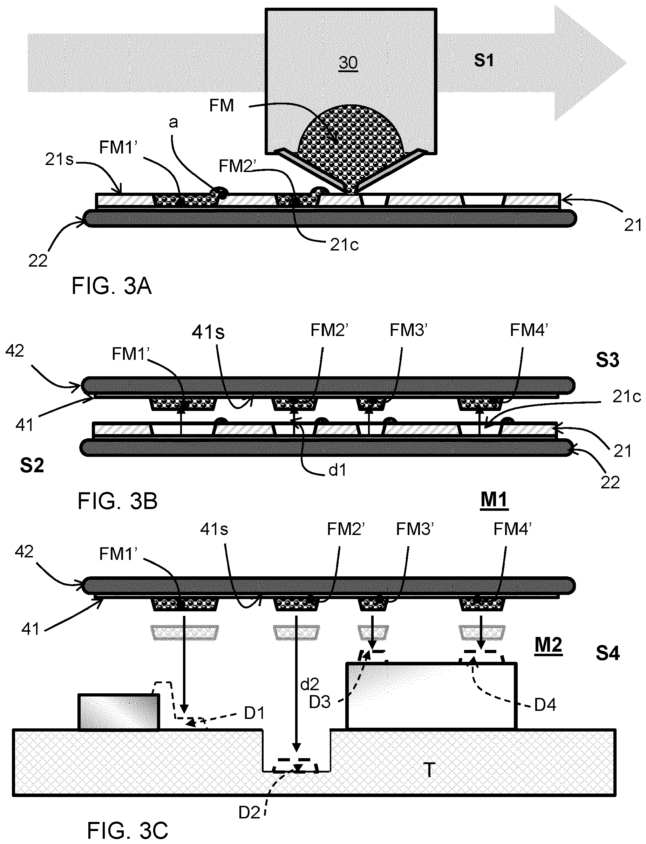

As shown in more detail in FIG. 2A, 2B, 3A, 3B and 3C, embodiments of the present invention are of particular value for applications wherein a highly detailed pattern for example having pattern elements of functional material species having a size of 100 µm and less, are deposited on a target having a profiled target surface.

FIG. 2A and 2B show a conventional deposition method, wherein the pattern of functional material species is directly transferred from a donor plate surface A21s of a donor plate A21 to the target surface TS.

As shown in FIG. 2A, during the filling of the cavities in the donor plate surface A21s of the donor plate A21, a portion (a) of the functional material FM is dragged out of the cavities by the filling device A30, e.g. a doctor blade.

As shown in FIG. 2B, the dragged out portion (a) of the functional material will cause the functional material species FM1', FM2', FM3', FM4' to transfer in a direction deviating from the intended direction (typically orthogonal to the surface A21s) and lead to misaligned transfer and/or a distortion of the pattern wherein the functional material were originally arranged. By way of example D1, D2, D3, D4 respectively indicate the intended deposition locations of the functional material species FM1', FM2', FM3', FM4'. The distortion and misalignment increases with the distance d1 between the surfaceA21s of the patterned donor plate A21 and the surface TS of the target T. This dependence is in particular problematic for deposition on patterned targeted surfaces, because the deviation from the intended deposition position D1, D2, D3, D4 of the functional material species FM1', FM2', FM3', FM4' will be mutually different, approximately proportional to the transfer distance.

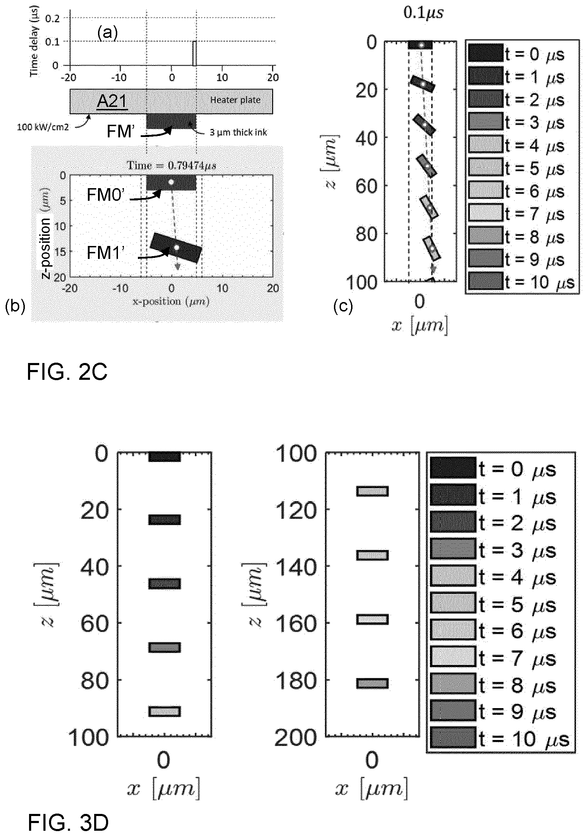

FIG. 2C shows a simulation of this phenomenon. Therein part (a) of FIG. 2C shows the specimen FM' of functional material on the surface of the donor plate A21. In this simulation it is presumed that the transfer from the donor plate A21 is induced with a heat flux of 100 kW/cm². The donor plate A21 is depicted herein as flat, and it is presumed that an edge of the specimen FM' receives the heat flux with a delay of 0.1 µs. This situation is equivalent to the case wherein the specimen is primarily deposited in a cavity of the donor plate surface, and wherein a portion of the specimen remains on the edge of the cavity. The main portion of the specimen receives the heat flux earlier than the edge portion as it is closer to the heat source. Due to the fact that the heat flux reaches the edge portion at a later time, the specimen remains sticked to the donor plate surface so that it is not fully accelerated. Once the heat flux reaches the edge portion a gas pressure is generated at that side of the specimen resulting in an asymmetric acceleration that causes the specimen to rotate. Therewith it is transferred in a deviating direction. Part (b) of FIG. 2C shows the specimen at two points in time. FM0' is the state of the specimen when it is still on the surface of the donor plate. FM1' is the state of the specimen at about 0.8 µs subsequent to the point in time of heat induced transfer. Part (b) of FIG. 2C further shows the location of the center of gravity. Part (c) of FIG.2C shows the specimen at further points in time in x-z coordinate system. As becomes apparent from this simulation, a delay of only 0.1 µs on the edge of a 10 µm line will lead to quite severe misalignment of 5 µm (50%) over a printgap of 100 µm. In this case the ejection trajectory deviates at rate of about 1 µm per 20 µm travel distance (2.9 degree). Typically the acceptable misalignment for industrial applications is about 10% of the line width, which means that the acceptable printgap for this linewidth and delay is around 20 µm.

FIG. 3A, 3B and 3C show subsequent operational stages of an embodiment of the improved deposition system. The operational stage of the improved deposition system shown in FIG. 3A corresponds to the operational stage of the known deposition system shown in FIG. 2A. Also here it will typically the case that a portion (a) of the functional material FM is dragged out of the cavities in the donor plate surface 21s by the filling device 30.

FIG. 3D shows a further simulation comparable with the simulation of FIG. 2C, wherein a 10 µm wide line is transferred from a flat transfer plate. Now the heat flux simultaneously arrives over the full length of the specimen, and shear forces are avoided. The left part of FIG. 3D shows the state of the specimen in x-z coordinates in the time interval from 0 µs to 4 µs. The right part of FIG. 3D further shows the state of the specimen in x-z coordinates in the time interval from 5 µs to 10 µs. In this simulation of an improved deposition method the lineshaped specimen transfers straight towards the target surface. The simulation shows that the transfer velocity is in the order of 20 - 25 m/s.

In a following operational stage as shown in FIG. 3B, the functional material species FM1', FM2', FM3', FM4' are transferred from the cavities 21c in the donor plate 21 to the surface 41s of a flat transfer plate 42. Also in this case dragged out portions (a) of the functional material will cause the functional material species FM1', FM2', FM3', FM4' to transfer in a direction deviating from the intended direction. However in sharp contrast to the situation depicted in FIG. 2B, the flat transfer plate 41 can be positioned close to the donor plate, so that the deposition positions of the functional material species FM1', FM2', FM3', FM4' are only minimally affected as a result of the deviation of their transfer direction. Moreover, the transfer distance is the same for each of the functional material species FM1', FM2', FM3', FM4' so that also the minimal deviation in the deposition position is substantially the same for each functional material species. Therewith the pattern defined by the deposited functional material species FM1', FM2', FM3', FM4' will substantially correspond to the pattern defined by the donor plate.

FIG. 3C show a subsequent operational stage, wherein the pattern of functional material species FM1', FM2', FM3', FM4' is transferred from the transfer plate 41 to the target T. In this operational stage the transfer distance d2 differs, dependent on the deposition locations D1, D2, D3, D4 of the functional material species FM1', FM2', FM3', FM4'. However, due to the fact that the functional material species FM1', FM2', FM3', FM4' are transferred from the flat surface of the transfer plate 41, the transfer direction is at least substantially orthogonal to the transfer plate surface. Therewith a deviation in the deposition position is mitigated. Also deviations in the deposition pattern from the pattern defined by the donor plate are mitigated.

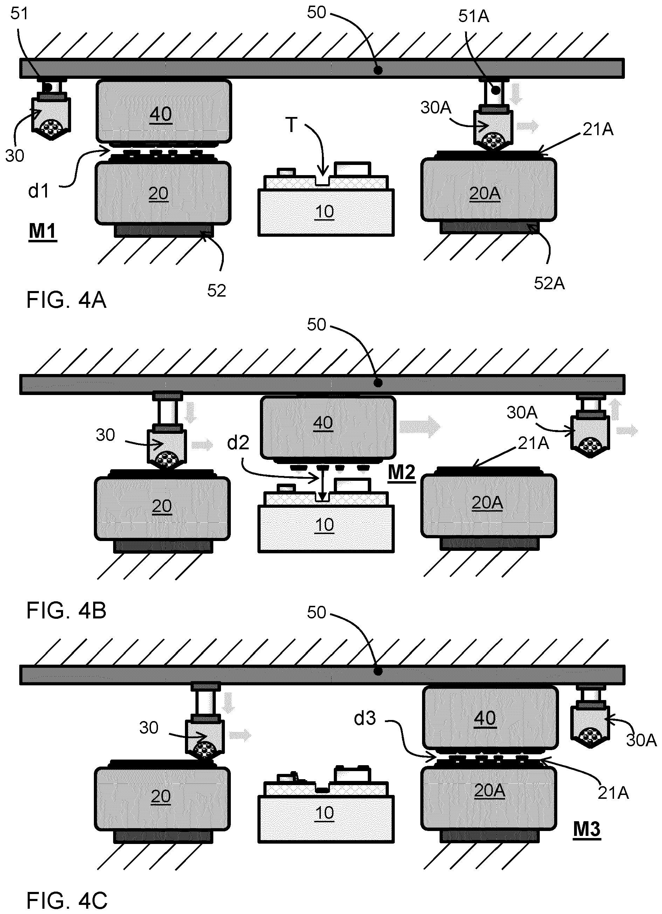

FIG. 4A, 4B, 4C show subsequent operational stages of a still further embodiment of the improved deposition system. As compared to the embodiments of the deposition system shown earlier in this application, the deposition system in this embodiment further comprises a further deposition unit 20A for a further donor plate 21A having a donor plate surface. Also the embodiment shown here comprises a further functional material supply device 30A that is configured to provide the donor plate surface of the donor plate of the further deposition unit 20A with a further functional material species.

The positioning mechanism 50, 51, 51A, 52, 52A is configured to controllably position the functional material supply device 30, the further functional material supply device 30A, the deposition unit 20, the further deposition unit 20A, the transfer unit 40 and the target T relative to each other.

FIG. 4A shows an operational stage similar to the operation stage shown in FIG. 1C wherein functional material species are transferred from the donor plate 21 on the deposition unit 20 to the transfer plate 41 on the transfer unit 40.

Likewise FIG. 4B shows an operational stage similar to the operation stage shown in FIG. 1E wherein functional material species are transferred from the transfer plate 41 on the transfer unit 40 to the target T

FIG. 4C shows a further operational stage performed in a third deposition mode M3, wherein the further functional material species FM' is transferred from the further donor plate 21A to the transfer plate 41.

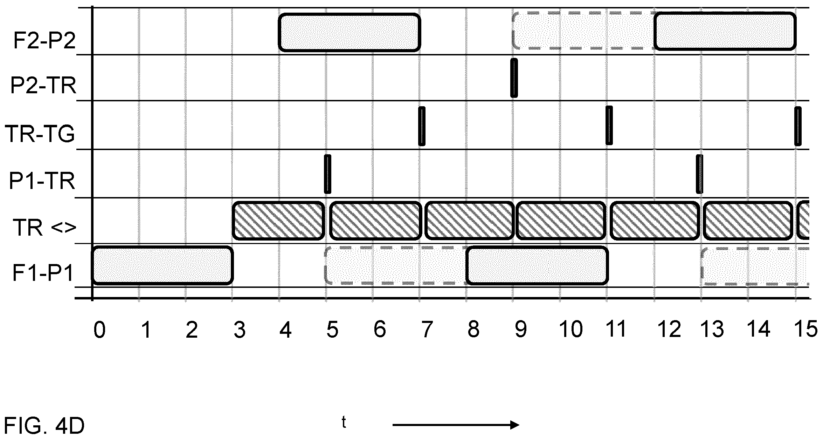

Therewith an additional increase in efficiency is possible as is illustrated in FIG. 4D.

In FIG. 4D the following operations are shown:
F1-P1: the functional material supply device 30 deposits the functional material species on the donor plate.
TR<>: The transfer unit 40 is moved in the direction X or -X.
P1-TR: Functional material species are transferred from the donor plate 21 on the deposition unit 20 to the transfer plate 41.
TR-TG: Functional material species are transferred from the transfer plate 41 to the target.
P2-TR: Functional material species are transferred from the donor plate 21A on the deposition unit 20A to the transfer plate 41.
F2-P2: the functional material supply device 30A deposits the functional material species on the further donor plate 21A.

In this embodiment a still further reduction in cycle time is achieved from 5 to 4 time units.

In embodiments wherein the deposition system is equipped with more than one deposition unit, these deposition units may be provided with mutually different types of donor plates, for example being patterned with a mutually different patterns or not being patterned. Additionally or alternatively, mutually different donor plates may be used for deposition of mutually different functional species.

For example some applications require printing copper pillars that end with a tin/silver top layer. The pillars can be printed in 3 times, and then the tin/silver in 1 time.

In another example the improved deposition system is used for printing of batteries, where electrolytes, conductors and separators are required in a stack.

In again another example the improved deposition system is used for printing of wrap-around electrodes for display applications, where it is desired to print higher aspect ratio lines to improve the wrapping behavior.

In a still further example the improved apparatus is used for printing of different quantum dots materials for display applications.

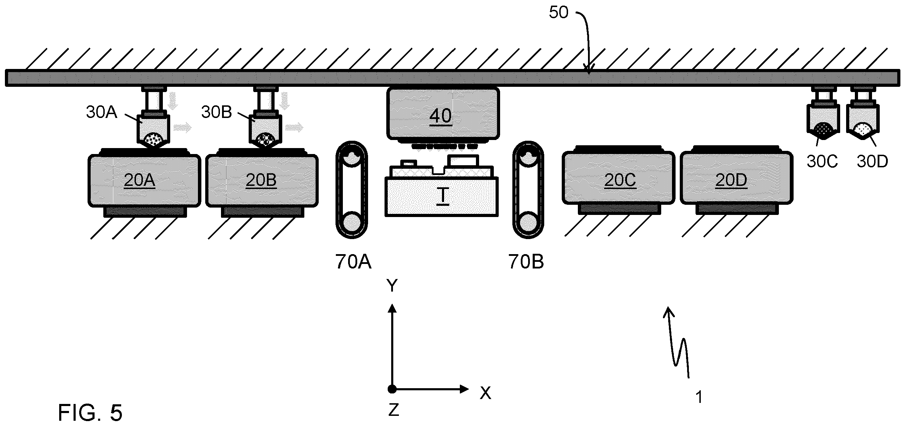

An example of an embodiment of the improved deposition system suitable for such various applications is shown in FIG. 5. In this example the deposition system 1 comprises a set of four deposition units 20A, 20B, 20C and 20D. The four deposition units 20A, 20B, 20C and 20D each have a proper functional material supply device 30A, 30B, 30C and 30D to provide the donor plate surface of the donor plate on their deposition unit with a respective functional material species.

The positioning mechanism 50 is configured to controllably position each functional material supply device 30A, 30B, 30C and 30D and the transfer unit 40 in the direction X. In the operational stage shown in FIG. 5, the functional material supply devices 30A and 30B provide the donor plates of the deposition units 20A and 20B each with a respective functional material. Also the transfer unit 40 is prepared for transferring a mixed pattern of functional species on its transfer plate on the surface of the target T. In a subsequent operational stage, when the mixed pattern has been transferred, the controller (not shown) controls the positioning mechanism 50 so as to move the functional material supply devices 30A and 30B in the direction -X. Also the controller (not shown) will control the positioning mechanism 50 to move the transfer unit 40 in the -X direction towards a position opposite the deposition unit 20A and cause the deposition unit 20A to transfer the pattern of functional material received from functional material supply device 30A to the surface of the transfer plate on the transfer unit 40. Further the controller will control the positioning mechanism 50 to move the transfer unit 40 in the -X direction towards a position opposite the deposition unit 20B and cause the deposition unit 20B to transfer the pattern of functional material received from functional material supply device 30B to the surface of the transfer plate on the transfer unit 40. Therewith the transfer plate is provided with a combined pattern composed of the patterns defined by the donor plates on the deposition unit 20A, 20B. The pattern transfer from the deposition unit 20A to the transfer unit 40 and the pattern transfer from the deposition unit 20B to the transfer unit 40 may be performed in the reverse order, unless it is important how functional material species are stacked upon each other on the surface of the transfer plate on the transfer unit 40. It is further noted that a single functional material supply device may suffice for both deposition units 20A, 20B if they need to be provided with the same functional material. However, also in this case it is favorable to use a proper functional material supply device for each deposition unit 20A, 20B for reducing cycle time. After the transfer plate has been provided with the combined pattern deposited thereon by the deposition units 20A, 20B, the controller controls the positioning mechanism 50 to move the transfer unit 40 in a position opposite the target T and subsequently controls the transfer unit 40 to deposit the combined pattern on the surface of the target T. In the meantime the controller also controls the positioning mechanism to position the functional material supply devices 30C and 30D in a position opposite the donor plates of the deposition units 20C and 20D, and controls the functional material supply devices 30C and 30D to provide the donor plates thereon each with a respective functional material. Subsequently, after completion of the transfer of the combined pattern originating from the deposition units 20A, 20B, the controller can control further steps wherein the transfer plate of the transfer unit 40 is provided with a new combined pattern of functional materials provided by the deposition units 20C, 20D. Likewise the controller then perform the steps necessary to transfer this new combined pattern to the surface of the target T. These control steps are analogous to the control steps described for preparing and deposition of the combined pattern mentioned before.

In the embodiment shown, the embodiment of the improved deposition system 1 comprises a pair of cleaning stations 70A, 70B. When a combined pattern has been transferred from the transfer plate to the target surface, the controller activates a cleaning station 70A, 70B to remove any remainders of functional material from the surface of the transfer plate. For example while the controller cause the positioning mechanism 50 to move the transfer unit 40 in the direction X, towards the deposition units 20C, 20D, the controller also activates the cleaning station 70B to clean the surface of the transfer plate before a new combined pattern is deposited thereon. The cleaning stations 70A, 70B are for example provided as a rotating damp cloth, which polishes/wipes the surface of the transfer plate clean before the next deposition.

It is noted that many variations are possible. For example the deposition system 1 may be configured in a manner wherein first the pattern on the donor plate of each of the deposition units 20A, 20B, 20C, 20D is deposited as a combined pattern on the transfer plate and wherein subsequently this combined pattern is transferred to the surface of the target. Furthermore, at each side any number of deposition units may be provided, e.g. only one or more than two. Also dependent on the number of mutually different functional species to be deposited the number of functional material supply devices may be less than the number of deposition units 20. Whereas FIG. 5 shows an embodiment wherein all components are arranged in a direction X and the positioning system primarily controls the relative positions in that direction, other embodiments are conceivable that are extended in more than one direction. For example embodiments comprising a further set of deposition units that are arranged in the direction Z, and a further set of functional material supply devices that are controllably movable in that direction for providing the donor plates on the further deposition units with their functional material. For example the transfer unit 40 is movable in the Z-direction so as to enable transfer of a pattern of further material species originating from the further deposition units. Alternatively a separate further transfer unit is provided for this purpose. It is noted that also in the embodiment shown in FIG. 5 one or more further transfer units may be provided, for example a separate transfer unit for the transfer of a combined pattern from the deposition units 20A, 20B and one for the transfer of a combined pattern from the deposition units 20C, 20D.

## Claims

1. A deposition method for depositing a functional material (FM) onto a target surface (TS) of a target (T), the method comprising:
providing (S1) a donor plate surface (21s) of a donor plate (21) with a functional material species (FM') of the functional material (FM);
supplying (S2) heat to the donor plate surface to expel the functional material species (FM') away therefrom;
**characterized by**:
receiving (S3) on a transfer surface (41s) of a transfer plate (41) the expelled functional material species (FM'); and
supplying (S4) heat to the transfer surface (41s) of the transfer plate (41) to transfer the functional material species (FM') for deposition on the target surface (TS) of the target (T).

2. The deposition method according to claim 1, wherein the functional material species (FM') is displaced over a first distance (d1) after being expelled away from the donor plate and until being received on the transfer surface (41s) of the transfer plate (41), wherein the functional material species (FM') is displaced over a second distance (d2) when it is transferred from the transfer surface (41s) to the target surface (TS) of the target (T), and wherein the second distance (d2) is greater than the first distance (d1).

3. The deposition method according to claim 2, wherein providing (S1) a donor plate (21) with a functional material species (FM') comprises filling (S1) at least one cavity (21c) that is patterned in a surface (21s) of the donor plate (21) with the functional material species (FM').

4. The deposition method according to claim 1, 2 or 3,
providing (S1A) a further donor plate surface (21s) of a further donor plate (21) with a further functional material species (FMa') of a further functional material (FMa);
supplying (S2A) heat to the further donor plate surface to expel the further functional material species (FMa') away therefrom;
on the transfer surface (41s) of the transfer plate (41) receiving the expelled further functional material species (FM'),
when supplying (S4) heat to the transfer surface (41s) of the transfer plate (41) transferring the further functional material species (FMa') for deposition on the target surface (TS) of the target (T).

5. The deposition method according to claim 4, wherein further functional material (FMa) and the functional material (FM) are mutually different substances.

6. The deposition method according to claim 4 or 5, wherein the functional material species (FM') and the further functional material species (FMa') are transferred simultaneously when supplying (S4) heat to the transfer surface (41s) of the transfer plate (41).

7. The deposition method according to one of the preceding claims, wherein the functional material has a viscosity higher than 0.1Pa.s.

8. The deposition method according to one of the preceding claims, wherein the functional material comprises one or more of a solvent, an acrylate type polymer, an epoxy type polymer or a silicone type polymer.

9. The deposition method according to claim 8, wherein the functional material further comprises a solid state material.

10. The deposition method according to one of the preceding claims, wherein the functional material comprises at least one component having an evaporation temperature of at most 800 _{°}C.

11. A deposition system (1) for depositing a functional material (FM) onto a target surface (TS) of a target (T), the system comprising:
a target holder (10) for holding the target (T);
a deposition unit (20) for holding a donor plate (21) having a donor plate surface (21s);
a functional material supply device (30) configured to provide the donor plate surface (21s) with a functional material species (FM') of the functional material (FM);
the deposition unit comprising a heat supply facility (22) configured to supply heat to expel functional material species (FM') from the donor plate surface (21s);
**characterized by**:
a transfer unit (40) for holding a transfer plate (41) having a transfer plate surface (41s) and comprising a further heat supply facility (42) configured to supply heat to the transfer surface (41s) of the transfer plate (41);
a positioning mechanism (50, 51, 52) configured to controllably position the filling device (30), the deposition unit (20), the transfer unit (40) and the target (T) relative to each other;
a controller (60) configured to control the functional material supply device (30), the heat supply facility (22), the further heat supply facility (42) and the positioning mechanism (50, 51, 52, 53),
the deposition system having at least a first deposition mode (M1), wherein the functional material species (FM') is transferred from the donor plate (21) to the transfer plate (41) with the donor plate (21) facing the transfer plate (41) and a second deposition mode (M2), wherein the functional material species (FM') is transferred from the transfer plate (41) to the target (T) with the transfer plate (41) facing the target (T).

12. The deposition system (1) according to claim 11, in the first deposition mode (M1) being configured to transfer the functional material species (FM') over a first distance (d1) from the surface of the donor plate to the transfer surface (41s) of the transfer plate (41), and in the second deposition mode (M2) being configured to displace the functional material species (FM') over a second distance (d2) from the transfer surface (41s) to the target surface (TS) wherein the second distance (d2) is greater than the first distance (d1).

13. The deposition system (1) according to claim 12 configured for holding a donor plate (21) having a donor plate surface (21s) patterned with at least one cavity (11c).

14. The deposition system (1) according to one of the claims claim 10 - 13, further comprising:
at least a further deposition unit (20A, 20B, 20C, 20D) for a further donor plate (21B) having a donor plate surface;
at least a further functional material supply device (30A, 30B, 30C, 30D) configured to provide the donor plate surface (21s) of the donor plate of the further deposition unit (20B) with a further functional material species (FM');
the positioning mechanism (50, 51, 52) being configured to controllably position the functional material supply device (30), the further functional material supply device (30B), the deposition unit (20), the further deposition unit (20B), the transfer unit (40) and the target (T) relative to each other;
the deposition system further having a third deposition mode (M3),
wherein the further functional material species (FM') is transferred over a third distance from the further donor plate (21') to the transfer plate (41).

15. The deposition system according to claim 14, being configured to simultaneously transfer the functional material species (FM') and the further functional material species (FMa') when supplying (S4) heat to the transfer surface (41s) of the transfer plate (41).

16. A record carrier (80) comprising a computer program with instructions to cause a programmable device to perform the method of any of claims 1-10.
